# EUROPÄISCHE PATENTANMELDUNG

(11) **EP 1 401 010 A1**
(43) Veröffentlichungstag der Anmeldung: **24.03.2004**
(21) Anmeldenummer: 02020460.8
(22) Anmeldetag: 12.09.2002
(51) Int. Cl.: H01L 21/00, B24B 49/04, B23Q 15/16, B23Q 23/00

(54) **Vorrichtung und Verfahren zur Messung und Kompensation der Abnutzung von Bürsten bei Bürstmaschinen**

(71) Anmelder: Niederberger Schleif- und Polierautomaten AG, 6010 Kriens (CH)
(72) Erfinder: Niederberger, Ernst, 6370 Oberdorf (CH)
(74) Vertreter: Blum, Rudolf Emil Ernst

(57) **Zusammenfassung**

Die Bürst- und Entgratmaschine weist eine Vorrichtung zur Steuerung der Position der Bürsten (2) auf. Mittels eines Pneumatikzylinders (5) wird eine Tastplatte (1) gegen die Bürste (2) gedrückt. Mit einem Lineargeber (10) wird die Position der Tastplatte (1) gemessen. Ausgehend von dieser Messung wird die Position der Bürsten (2) bei Abnützung angepasst. Die Messung und Anpassung ist ohne Betriebsunterbruch möglich und wird periodisch durchgeführt. Die Vorrichtung ermöglicht eine präzise und zuverlässige Kompensation der Bürstenabnutzung.

## Beschreibung

Vorrichtung gemäss Oberbegriff des Anspruchs 1 und ein Verfahren gemäss Oberbegriff des Anspruchs 11.

Vorrichtungen und Verfahren dieser Art, wie sie in US 4,382,308 beschrieben sind, werden verwendet um eine Wirkgrösse von Bürsten bei Bürstmaschinen zu messen. Eine Wirkgrösse ist dabei ein Wert, welcher zumindest einen Hinweis auf die Wirksamkeit einer Bürste gibt. Durch Abnutzung nimmt die Wirksamkeit einer Bürste ab. Ziel einer Abnutzungskompensation ist es die Wirksamkeit von Bürsten konstant zu halten. Konventionelle Vorrichtungen wie die in US 4,382,308 beschriebene messen die Leistung der Bürstenantriebe. Eine Abnutzung der Bürsten wird dabei aufgrund einer verringerten Leistung festgestellt. Diese Messwerte sind ungenau und für die Steuerung einer Abnützungskompensation nur bedingt geeignet, weil sie von weiteren Faktoren, wie zum Beispiel der Art und Anzahl der Werkstücke, der verbleibenden Borstenlänge und dem Betriebszustand der Motoren abhängig sind. Andere Vorrichtungen wiederum messen optisch die Borstenlänge der Bürsten, insbesondere mit Laser. Diese Art der Messung hat den Nachteil, dass im Wesentlichen nur die maximale Borstenlänge messbar ist und eine optische Messvorrichtung wegen der Schleif- und/oder Kühlmittel und des Abriebs im Bereich der Bürsten schwierig zu konstruieren, störungsanfällig und wartungsbedürftig ist.

Es stellt sich daher die Aufgabe, eine Vorrichtung der eingangs genannten Art bereitzustellen, die die oben genannten Nachteile zumindest teilweise vermeidet.

Diese Aufgabe wird von Anspruch 1 gelöst, indem die Vorrichtung eine Tastplatte, ein Mittel um die Tastplatte gegen die Bürsten zu drücken und ein Mittel zur Messung der Position der Tastplatte aufweist. Mit dieser Anordnung lässt sich die Abnutzung der Bürsten, d.h. eine Verkleinerung der effektiv wirksamen, durchschnittlichen Länge der Borsten, genauer messen als mit bekannten Verfahren. Zudem ist die Messung im Betrieb, d.h. bei eingespannten und in Bearbeitung befindlichen Werkstücken möglich. Dies hat den Vorteil, dass die Messung häufig durchgeführt werden kann, ohne dass es zu Zeitverlusten beim Bearbeitungsprozess kommt.

Es stellt sich zudem die Aufgabe, ein Verfahren der eingangs genannten Art bereitzustellen, das die oben genannten Nachteile zumindest teilweise vermeidet.

Diese Aufgabe wird von Anspruch 11 gelöst, indem eine Tastplatte gegen Bürsten der Bürstmaschine gedrückt wird und die Position der Tastplatte gemessen wird. Die mit diesem Verfahren bestimmte Wirkgrösse ist genauer und charakterisiert die Bürsten und insbesondere deren Abnutzung besser als die bekannten Verfahren, wie z.B. das Messen der Leistung der Bürstenantriebe.

Weitere Vorteile und bevorzugte Ausführungsbeispiele ergeben sich aus den abhängigen Ansprüchen, sowie aus der nun folgenden Beschreibung anhand der Figuren. Dabei zeigen:
Fig. 1 Eine Bürstmaschine mit einer bevorzugten Ausführungsform der erfindungsgemässen Messvorrichtung in einer Teilansicht von der Seite,
Fig. 2 Die Bürstmaschine aus Fig. 1 in einem Schnitt entlang der Line II,
Fig. 3 Die Bürstmaschine aus Fig. 1 in einer Teilansicht von unten,
Fig. 4 Bürstmaschine mit einer weiteren bevorzugten Ausführungsform der erfindungsgemässen Messvorrichtung in einer Teilansicht von der Seite.

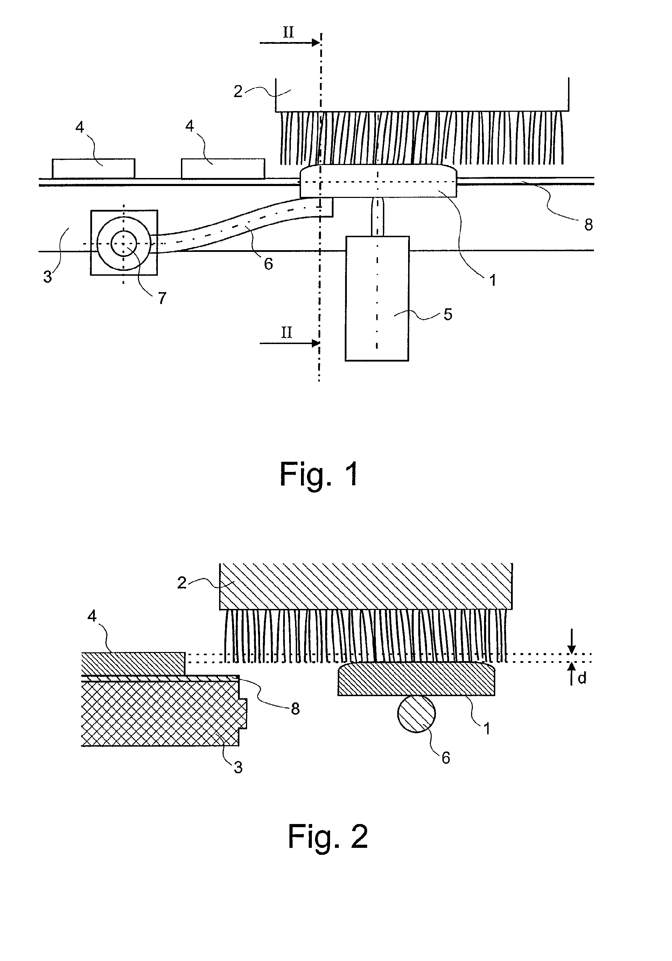

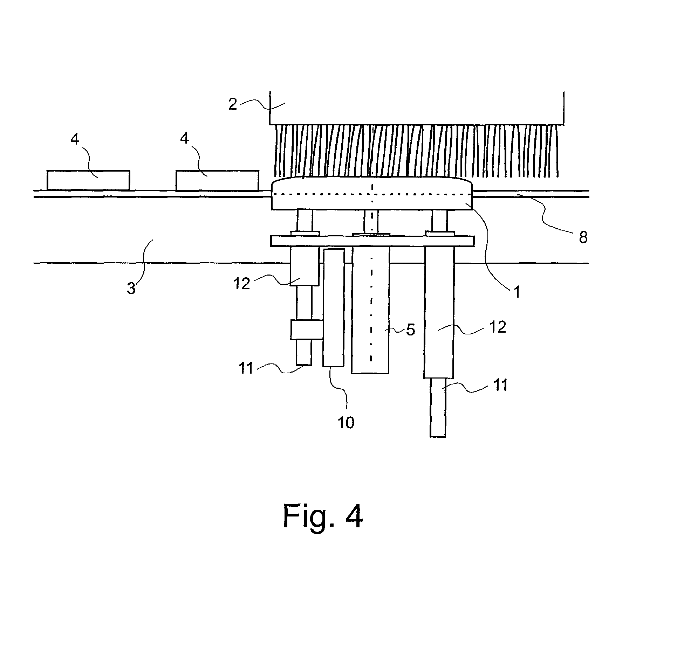

Fig. 1 zeigt eine Bürstmaschine mit einer bevorzugten Ausführungsform der erfindungsgemässen Messvorrichtung 1, 5, 6 ,7 in einer Teilansicht von der Seite. Derartige Bürstmaschinen werden unter anderem zum Bürsten und Entgraten von Werkstücken 4, insbesondere Metallteilen, eingesetzt. Die Bürsten 2 sind in einer Planeteneinheit angeordnet, von der jedoch nur eine Bürste 2 gezeigt ist. Bei den gezeigten Bürsten 2 handelt es sich um Tellerbüsten. Die erfindungsgemässe Vorrichtung bzw. das erfindungsgemässe Verfahren eignet sich jedoch auch für andere Bürstenarten, wie z.B. Walzenbürsten. Die Werkstücke 4 werden mit der Bürste 2 gebürstet und dadurch insbesondere geschliffen und entgratet. Die Werkstücke 4 sind vorzugsweise magnetisch auf einem Gurt bzw. Förderband 8 gehalten. Der Gurt ist dazu auf einem Magnettisch 3 geführt. Die Bürsten 2 werden bei der Bearbeitung der Werkstücke abgenützt, d.h. insbesondere ihre Borstenlänge nimmt ab. Diese Abnutzung wird durch ein Zustellen der Bürsten kompensiert. Um eine geeignete Zustelldistanz bzw. -frequenz zu ermitteln wird eine Wirkgrösse der Bürste 2 gemessen. Erfindungsgemäss erfolgt dies über die Messung der Position einer mit einer bestimmten Kraft gegen die Bürste 2 gedrückten Tastplatte 1. Die Andruckkraft wird bevorzugt mittels einem Pneumatikzylider 5 ausgeübt. Die derart bestimmte Wirkgrösse charakterisiert den Abnutzungsgrad der Bürste 2 sehr gut, insbesondere weil in sie mehrere physikalische Eigenschaften der Bürste eingehen, so z.B. die Borstenlänge und die Steifigkeit bzw. Elastizität der Borsten. Die Tastplatte 1 ist bevorzugt an einer sehr leicht zu bewegenden Haltevorrichtung montiert. So gibt es keine Kraftverluste und die Messvorrichtung ist dadurch sehr feinfühlig. Bei der gezeigten Ausführungsform ist die Tastplatte 1 ist an einem Arm 6, insbesondere einem dünnen Rundeisen befestigt. Der Arm 6 ist mit Gelenk 7 gelagert. Die Befestigung, bzw. Lagerung der Tastplatte 1 mit einem Arm 6 hat den Vorteil, dass sie so sehr fein, ohne wesentlichen Widerstand beweglich ist. Eine weitere bevorzugte Ausgestaltung der Haltevorrichtung der Tastplatte 1 ist weiter unten anhand von Fig.4 beschrieben. Zumindest die obere Hälfte der Tastplatte 1 ist vorzugsweise allseitig verrundet und aus einem möglichst beständigen Material, d.h. einem Material, dass durch wiederholtes Bürsten bzw. Schleifen nicht wesentlich abgetragen wird. Bei Messungen wird die Tastpatte 1 bevorzugt mittels eines Pneumatikzylinders 5 gegen die Bürste 2 gedrückt. Dazu wird einer Luftkammer des Pneumatikzylinders 5 über einen Servodruckregler Druckluft zugeführt. Dieser Aufbau hat den Vorteil, dass die Andruckkraft sehr präzise geregelt werden kann. Eine typische Andruckkraft der Tastplatte 1 ist ca. 20 bis 30 N. In einer speziellen Ausführung der Erfindung sind Messungen mit unterschiedlichen Andruckkräften vorgesehen. Anstelle des Pneumatikzylinders 5 ist auch ein elektromechanischer Antrieb der Tastplatte 1 möglich. Bei der gezeigten Messvorrichtung bilden Tastplatte 1, Arm 6 und Gelenk 7 zusammen eine Messmechanik. Diese Messmechanik wird seitlich am Transporttisch bzw. Magnettisch 3 angebracht. Der Arm 6 ist so lang ausgestaltet, dass die Oberfläche der Tastplatte 1 bei Messungen im Wesentlichen gleich gerichtet und insbesondere horizontal bleibt. Die Vorrichtung weist einen Lineargeber, insbesondere ein Linearpotentiometer auf. Dieses ist entweder neben oder im Pneumatikzylinder 5 angeordnet. Die Anordnung im Pneumatikzylinder 5 hat den Vorteil, dass das Linearpotentiometer dort vor Verunreinigung durch Kühl-, Polier- und/oder Schleifmittel bzw. Abrieb geschützt ist. Dadurch ist kein separates Gehäuse für den Lineargeber erforderlich. Dieses senkt die Kosten. Der Lineargeber ist im Pneumatikzylinder zudem besser geschützt als in einem Gehäuse, weil zumindest zeitweise im Pneumatikzylinder 5 ein Überdruck herrscht, wodurch ein Eindringen von Verunreinigungen nahezu verunmöglicht wird. Der Pneumatikzylinder 5 hat bevorzugt auf jeder Kolbenseite eine Kammer, wobei für jede der Kammern ein Servodruckregler vorgesehen ist. Die Tastplatte 1 kann so nach der Messung, bzw. zwischen zwei Messungen aktiv aus dem Wirkbereich der Bürste 2 entfernt werden, wodurch deren Abnutzung reduziert wird. Es ist jedoch auch eine Variante mit nur einer Kammer, bzw. mit nur einem Servodruckregler, möglich, wobei dann das Entfernen der Testplatte 1 aus dem Wirkbereich der Bürste 2 z.B. durch Schwerkraft oder Federkraft erfolgen kann.

Fig. 2 zeigt die Bürstmaschine aus Fig. 1 in einem Schnitt entlang der Line II. Die Werkstücke 4 tauchen um die Länge d in die Bürste 2 ein. Die Länge d wird deshalb Eintauchtiefe genannt. Ziel der erfindungsgemässen Vorrichtung ist es diese Eintauchtiefe konstant zu halten. Je nach Art der Bürste 2 ist für eine optimale Bearbeitung eine bestimmte Eintauchtiefe erforderlich. Die Tastplatte 1 ist in einer Messpostion gezeigt, das heisst sie liegt auf den Borsten der Bürste 2 auf. Die Andruckkraft der Tastplatte ist dabei bevorzugt so gewählt, dass die Tastplatte 1 im Gegensatz zu den Werkstücken 4 nicht wesentlich in die Bürste eintaucht.

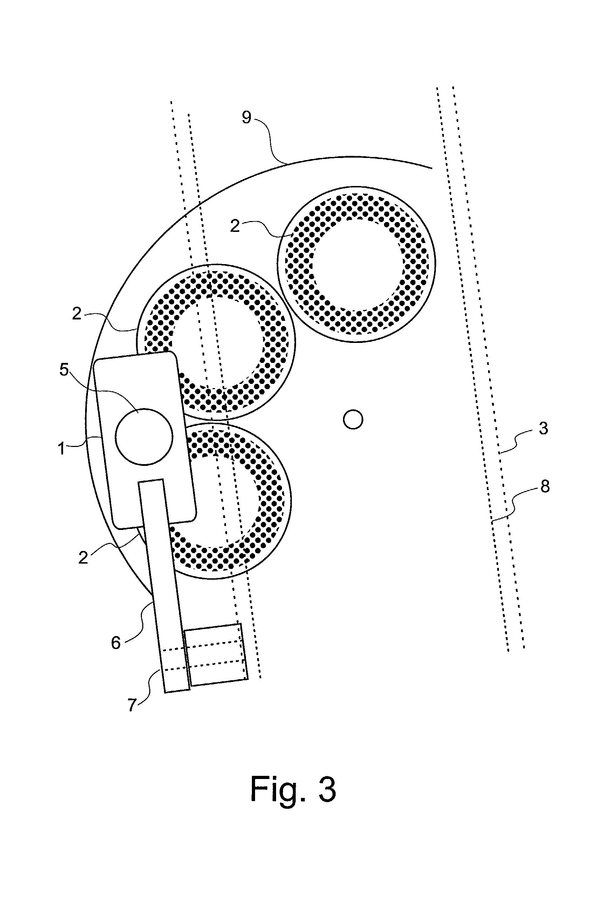

Fig. 3 zeigt die Bürstmaschine aus Fig. 1 in einer Ansicht von Unten. Der Magnettisch 3 und der Gurt 8 sind nur schematisch gezeigt. Die Tastplatte 1 ist bevorzugt so angeordnet und dimensioniert, dass sie sich im Betrieb, d.h. bei einer Rotation der Planeteneinheit 9 und Bewegung der Bürsten 2 entlang eines kreisförmigen Pfades, zu jedem Zeitpunkt mit dem Borstenbereich einer Bürste 2 überschneidet. Dies hat den Vorteil, dass die Messung zu jedem Zeitpunkt ohne Unterbrechung oder Überwachung des Bürstvorganges vorgenommen werden kann. Die gezeigten Bürsten 2 sind Tellerbürsten und haben daher einen ringförmigen Borstenbereich, d.h. in der Mitte der Bürste 2 sind keine Borsten vorgesehen. Die Tastplatte 1 ist bevorzugt länglich und insbesondere rechteckig ausgestaltet, weil so die Überschneidung bzw. Überdeckung mit dem Borstenbereich der Bürsten 2 besser gewährleistet ist. Die Tastplatte 1 ist bevorzugt bezüglich iherer Längsrichtung parallel zum Magnettisch 3, bzw. zum Gurt 8, ausgerichtet. Bei der gezeigten Ausführungsform der Messmechanik mit einem Arm 6 ist dieser ebenfalls in parallel zum Magnettisch ausgerichtet. Der Arm 6 kann jedoch auch quer zum Magnettisch 3 ausgerichtet werden. Die Anordnung der Tastplatte 1 neben dem Fördergurt 8 hat den Vorteil, dass die Messung unabhängig davon vorgenommen werden kann, ob gerade Werkstücke in der Maschine eingespannt sind bzw. mittels Fördergurt 8 über den Magnettisch 3 bewegt werden. Das Gelenk 7 des Arms 6 kann in Transportrichtung des Fördergurtes 8 vor- oder nachläufig angeordnet sein.

Fig. 4 zeigt eine Bürstmaschine mit einer weiteren bevorzugten Ausführungsform der erfindungsgemässen Messvorrichtung in einer Teilansicht von der Seite. Im Gegensatz zu der in Fig. 1 bis 3 beschriebenen Ausführungsform ist die Tastplatte 1 nicht mit einem Arm sondern nach dem Prinzip eines Linearschlittens mit Führungsstangen 11 bzw. Führungslagern 12 verschiebbar gelagert. Bevorzugt sind zwei Führungsstangen 11 und zwei Führungslager 12 vorgesehen, wobei diese in gleichem Abstand vom Magnettisch 3 in der Förderrichtung gesehen hintereinander angeordnet sind. Führungsstangen 11, Führungslager 12 und deren Halterung bilden zusammen eine Messmechanik. Im Gegensatz zu der in Fig. 1 bis 3 beschriebenen Ausführungsform ist der Lineargeber bzw. das Linearpotentiometer 10 getrennt vom Pneumatikzylinders 5 angeordnet. Dies hat den Vorteil, dass die beiden Teile nicht speziell aufeinander abgestimmt sein müssen und deshalb kostengünstigere Bauteile eingesetzt werden können. Das Linearpotentiometer ist bevorzugt nicht direkt mit der Tastplatte 1 sondern mit einer der Führungsstangen 11 verbunden, was die Verschmutzung des Linearpotentiometers reduziert.

Die mit Tastplatte 1 ermittelten Messdaten haben bei einer bevorzugten Ausführungsform der Erfindung eine Genauigkeit von ca. 1/10 mm. Die Abnutzungsgeschwindigkeit und Lebensdauer der Tellerbürsten variiert stark und hängt von vielen verschiedenen Faktoren ab. Als Beispiel sei hier eine Lebensdauer von ca. 20 Stunden genannt, wobei während dieser Zeit eine Borstenlänge von ca. 20 mm abgenützt wird.

Für die Regelung oder Steuerung der Position der Bürsten 2 wird in einem ersten Schritt der Pneumatikzylinder über mindestens einen Servodruckregler so angesteuert, dass er die Tastplatte 1 mit einer bestimmten Kraft, bzw. einem bestimmten Druck, gegen die Bürsten 2 drückt. Dieser Druck wird bevorzugt einige Sekunden aufrecht erhalten. Während dieser Zeit wird die Position des Lineargebers ausgelesen, vorzugsweise so, dass Vibrationen und andere Fehlerquellen durch eine Mittelung mehrerer Messresultate ausgeglichen werden. Anschliessend wird die Tastplatte 1 bevorzugt wieder aus dem Bereich der Borsten entfernt, insbesondere um ihre Abnutzung gering zu halten. Dies geschieht vorzugsweise ebenfalls durch eine geeignete Ansteuerung des mindestens einen Servodruckreglers des Pneumatikzylinders 5. Sobald für die Position der Tastplatte 1 ein Messwert vorliegt wird dieser mit einem Sollwert verglichen und die Position der Bürsten 2 entsprechend angepasst. Diese Anpassung kann im Sinne einer Feedbackregelung noch während der Messung erfolgen, oder aber erst nach Abschluss der Messung, wobei dann bevorzugt nur ein einziger Befehl zur Positionierung der Bürsten 2 generiert bzw. ausgeführt wird. Im Normalfall handelt es sich dabei um ein Zustellen um eine bestimmte Zustelldistanz. Dabei wird bevorzugt die Bürste 2 entsprechend ihrer Abnutzung auf den Werkstückhalter 3, 8 und die davon gehaltenen Werkstücke 4 zubewegt. Bei der in Fig. 3 gezeigten Ausführung besteht der Werkstückhalter 3, 8 aus dem Magnettisch 3 und dem darauf geführten Fördergurt 8. Die erfindungsgemässe Bürstmaschine kann jedoch auch so ausgestaltet werden, dass bei einem Zustellen nicht die Bürste 2 auf den Werkstückhalter, sondern umgekehrt der Werkstückhalter auf die Bürste zubewegt wird. Tastplatte 1, Pneumatikzylinder 5 und Tastarm 6 werden dabei bevorzugt zusammen mit dem Werkstückhalter bewegt.

Ein bevorzugtes Intervall zwischen zwei aufeinanderfolgenden Mess- und Zustellvorgängen liegt in einem Bereich zwischen drei und zehn Minuten, also z.B. fünf Minuten. Die Mess- und Zustellvorgänge laufen parallel zum Bürstvorgang. Für die Kompensation der Bürstenabnützung sind daher keine Betriebsunterbrüche erforderlich.

Der Sollwert für die Position der Tastplatte 1 kann auf verschiedene Arten bestimmt und eingestellt werden:

Bei einer ersten Variante werden die Bürsten 2 so weit an das Werkstück herangefahren, dass sie es gerade "ankratzen". Anschliessend werden die Bürsten um die Länge der gewünschten Eintauchtiefe abgesenkt. Danach wird die Testplatte 1 mittels Pneumatikzylinder 5 gegen mindestens eine Bürste 2 gedrückt. Die Position der Tastplatte 1 wird gemessen und als Sollposition gespeichert. Die Vorrichtung weist hierfür spezielle Bedienelemente auf, mittels derer eine automatische Messung und Speicherung der Sollposition ausgelöst werden kann.

Bei einer zweiten Variante werden ebenfalls die Bürsten 2 so weit an das Werkstück herangefahren, dass sie es gerade "ankratzen". Danach wird der Pneumatikzylinder 5 betätigt und die Position der angedrückten Tastplatte 1 gemessen. Diese Position wird als Referenzposition gespeichert. Die Sollposition wird rechnerisch, bzw. elektronisch durch Subtraktion einer zuvor gespeicherten Eintauchtiefe bestimmt. Die Vorrichtung weist hierfür zwei Bedienelemente auf. Ein erstes zur Eingabe und Speicherung der gewünschten Eintauchtiefe und ein zweites, mittels dessen eine automatische Messung und Speicherung der Referenzposition ausgelöst werden kann.

Die erfindungsgemässe Vorrichtung und das erfindungsgemässe Verfahren kann auch mit anderen, bekannten Vorrichtungen und Verfahren zur Messung und Kompensation der Bürstenabnützung kombiniert werden, z.B. mit der eingangs erwähnten antriebsleistungsbasierten Abnützungskompensationssteuerung. Es wird dadurch eine noch bessere Präzision und Zuverlässigkeit erreicht.

Es sei zudem bemerkt, dass neben der in diesem Dokument beschriebenen Steuerung der Position der Bürsten zum Zwecke der Bürstleistungssteuerung und Abnützungskompensation meistens auch weitere Positionierungen der Bürsten, z.B. zum Zwecke der Vergrösserung bzw. Vereinheitlichung des Wirkbereiches oder der Anpassung des Wirkbereiches an bestimmte Werkstückformen, erfolgen können. Ein Beispiel hierfür sind die anhand der Figuren beschriebenen Bürstmaschinen mit Planeteneinheit, bei denen durch eine Bewegung der Bürsten entlang kreisförmiger Pfade eine bessere räumliche Verteilung der Bürstleistung erzielt wird. Derartige Steuerungen der Position der Bürsten können parallel zur erfindungsgemässen Steuerung erfolgen. Es ist insbesondere auch eine Integration der Steuereinheiten möglich, d.h. dass z.B. ein gemeinsamer Mikroprozessor sowohl eine erfindungsgemässe Positionssteuerung, z.B. zur Abnützungskompensation, als auch weitere Positionssteuerungen, z.B. zur Anpassung an Werkstücke, vornimmt.

Auch wenn sich das vorliegende Dokument primär auf die Kompensation von Bürstenabnutzung bezieht, so kann die erfindungsgemässe Vorrichtung und das erfindungsgemässe Verfahren auch für die Messung und Kompensation der Abnützung von anderen Werkzeugen, wie z.B. von Schleifscheiben eingesetzt werden.

## Patentansprüche

1. Vorrichtung zur Messung einer Wirkgrösse von mindestens einer Bürste (2) bei Bürstmaschinen, **dadurch gekennzeichnet, dass** die Vorrichtung
- eine Tastplatte (1),
- ein Mittel um die Tastplatte (1) gegen die mindestens eine Bürste (2) der Bürstmaschine zu drücken, insbesondere mit einer bestimmten Kraft, und
- ein Mittel zum Messen der Position der Tastplatte (1) aufweist.

2. Vorrichtung gemäss Anspruch 1, **dadurch gekennzeichnet, dass** die Tastplatte (1) an mindestens einer Führungsstange (11) oder an einem Arm (6) befestigt ist, insbesondere an einem Arm (6), welcher mit einem Gelenk (7) schwenkbar gelagert ist.

3. Vorrichtung gemäss einem der vorhergehenden Ansprüche, **dadurch gekennzeichnet, dass** das Mittel zur Messung der Position der Tastplatte (1) ein Lineargeber ist, insbesondere ein Linearpotentiometer.

4. Vorrichtung gemäss einem der vorhergehenden Ansprüche, **dadurch gekennzeichnet, dass** das Mittel um die Tastplatte (1) gegen die mindestens eine Bürste (2) der Bürstmaschine zu drücken einen Pneumatikzylinder (5) aufweist.

5. Vorrichtung gemäss den Ansprüchen 3 und 4, **dadurch gekennzeichnet, dass** der Lineargeber (10) neben dem Pneumatikzylinder (5) oder im Pneumatikzylinder (5) angeordnet ist.

6. Vorrichtung zur Steuerung der Position von mindestens einer Bürste (2) bei Bürstmaschinen, **dadurch gekennzeichnet, dass** sie eine Vorrichtung zur Messung einer Wirkgrösse gemäss einem der Ansprüche 1 bis 5 und ein Mittel zur Steuerung der Position der mindestens einen Bürste (2) in Abhängigkeit von der gemessenen Position der angedrückten Tastplatte (1) aufweist.

7. Vorrichtung gemäss Anspruch 6, **dadurch gekennzeichnet, dass** sie ein Mittel zum Vergleich der gemessenen Position der Tastplatte (1) mit einer Sollposition und insbesondere ein Mittel zur Speicherung einer solchen Sollposition aufweist.

8. Vorrichtung gemäss einem der Ansprüche 6 oder 7, **dadurch gekennzeichnet, dass** die Vorrichtung ein Mittel zur Berechnung einer Sollposition der Tastplatte (1) aufweist, insbesondere zur Berechnung der Sollposition der Tastplatte (1) aus einer Referenzposition der Tastplatte (1) und einer Soll-Eintauchtiefe.

9. Bürstmaschine, **dadurch gekennzeichnet, dass** sie eine Steuervorrichtung gemäss einem der Ansprüche 6 bis 8 aufweist und insbesondere ein Mittel um die mindestens eine Bürste (2) auf ein Werkstück (4) zuzubewegen oder von einem Werkstück (4) wegzubewegen.

10. Bürstmaschine gemäss Anspruch 9, **dadurch gekennzeichnet, dass** sie mehrere Bürsten (2) aufweist, welche im Betrieb entlang mindestens eines Pfades bewegt werden und insbesondere in einer Planeteneinheit (9) angeordnete sind, und dass die Tastplatte (1) so angeordnet und dimensioniert ist, dass sie sich bei jeder im Betrieb möglichen Position der Bürsten (2) in einer Richtung senkrecht zur Tastplatte (1) betrachtet mit dem Borstenbereich mindestens einer Bürste (2) überschneidet oder überdeckt.

11. Verfahren zur Messung einer Wirkgrösse von mindestens einer Bürste (2) bei Bürstmaschinen, **dadurch gekennzeichnet, dass**
- eine Tastplatte (1) gegen die mindestens eine Bürste (2) der Bürstmaschine gedrückt wird,
- eine Messung durchgeführt wird, bei der die Position der Tastplatte (1) gemessen wird,
- die Tastplatte (1) insbesondere nach der Messung wieder aus dem Wirkbereich der Bürste (2) entfernt wird.

12. Verfahren zur Steuerung der Position von mindestens einer Bürste (2) bei Bürstmaschinen, **dadurch gekennzeichnet, dass** das Verfahren zur Messung einer Wirkgrösse gemäss Anspruch 11 durchgeführt wird und die Position der mindestens einen Bürste (2) aufgrund der gemessenen Position der angedrückten Tastplatte (1) gesteuert wird.

13. Verfahren gemäss Anspruch 12, **dadurch gekennzeichnet, dass** die Messung und eine allfällige Steuerung der Position der Bürsten (2) in Intervallen wiederholt wird, insbesondere in Intervallen im Bereich von drei bis zehn Minuten.

14. Verfahren gemäss einem der Ansprüche 12 oder 13, **dadurch gekennzeichnet, dass** die gemessene Position der angedrückten Tastplatte (1) mit einer Sollposition der Tastplatte (1) verglichen wird.

15. Verfahren gemäss Anspruch 14, **dadurch gekennzeichnet, dass** das Bestimmen der Sollposition der Tastplatte (1) die folgenden Schritte umfasst:
- Änderung der Position von mindestens einer Bürste (2), solange bis ein Werkstück (4) von der mindestens einen Bürste (2) gerade angekratzt wird,
- Zustellen der mindestens einen Bürste (2) um eine gewünschte Eintauchtiefe,
- Betätigung der Tastplatte (1), d.h. drücken der selben gegen die mindestens eine Bürste (2) und Messung der Position der angedrückten Tastplatte (1) und Speicherung dieser Position als Sollposition.

16. Verfahren gemäss Anspruch 14, **dadurch gekennzeichnet, dass** das Bestimmen der Sollposition der Tastplatte (1) die folgenden Schritte umfasst:
- Änderung der Position von mindestens einer Bürste (2), solange bis ein Werkstück (4) von der mindestens einen Bürste (2) gerade angekratzt wird,
- Betätigung der Tastplatte (1), d.h. drücken der selben gegen die mindestens eine Bürste (2) und Messung der Position der angedrückten Tastplatte (1), Speicherung dieser Position als Referenzposition,
- Eingabe einer gewünschten Eintauchtiefe, insbesondere über ein Bediengerät,
- Berechnung der Sollposition der Tastplatte (1) aus der Referenzposition und der gewünschten Eintauchtiefe.
